# EUROPÄISCHE PATENTSCHRIFT

(11) **EP 1 594 153 B1**
(45) Veröffentlichungstag und Bekanntmachung des Hinweises auf die Patenterteilung: **24.02.2010**
(21) Anmeldenummer: 04010696.5
(22) Anmeldetag: 05.05.2004
(51) Int. Cl.: H01J 37/34, C23C 14/34

(54) **Beschichtungsvorrichtung mit grossflächiger Anordnung von drehbaren Magnetronkathoden**
Coating device with rotatable magnetrons covering large area
Dispositif d'application de revêtement comprenant des magnétrons tournants couvrant une surface étendue

(43) Veröffentlichungstag der Anmeldung: 09.11.2005
(73) Patentinhaber: Applied Materials GmbH & Co. KG, 63755 Alzenau (DE)
(72) Erfinder: Bangert, Stefan, 36396 Steinau (DE); Fuchs, Frank, 63826 Geiselbach-Ommersbach (DE); Lindenberg, Ralph, 63654 Büdingen (DE); Lopp, Andreas, Dr., 63579 Freigericht-Somborn (DE); Schüssler, Uwe, 63743 Aschaffenburg (DE); Stolley, Tobias, 60598 Frankfurt am Main (DE)
(74) Vertreter: Bockhorni & Kollegen

(56) Entgegenhaltungen:
- US-A- 4 356 073
- US-A- 4 417 968
- US-A- 5 425 861
- US-A- 5 464 518
- US-A1- 2004 074 770
- US-B1- 6 488 824
- PATENT ABSTRACTS OF JAPAN Bd. 2003, Nr. 11, 5. November 2003 (2003-11-05) -& JP 2003 183823 A (SHARP CORP), 3. Juli 2003 (2003-07-03)
- WRIGHT M ET AL: "Design advances and applications of the rotatable cylindrical magnetron" JOURNAL OF VACUUM SCIENCE & TECHNOLOGY A (VACUUM, SURFACES, AND FILMS) USA, Bd. 4, Nr. 3, 1986, Seiten 388-392, XP002314779 ISSN: 0734-2101

## Beschreibung

Die vorliegende Erfindung betrifft eine Beschichtungsvorrichtung nach dem Oberbegriff des Anspruchs 1.

Beschichtungsvorrichtungen, bei denen mittels Kathodenzerstäubung die Beschichtung auf ein Substrat aufgebracht wird, sind seit längerem bekannt und werden für vielfältige Beschichtungszwecke eingesetzt. Das Design und die Konstruktion derartiger Beschichtungsvorrichtungen variieren in einem großen Maße mit den besonderen Anforderungen des Beschichtungszwecks. So gibt es beispielsweise unterschiedlichste Arten von Kathoden, wie z. B. planare Kathoden, Magnetronkathoden, rotierbare Magnetronkathoden usw.. Während bei planaren Kathoden das Beschichtungsmaterial, das zerstäubt werden soll in Form eines flachen, ebenen Targets ausgebildet ist, sind beispielsweise bei sog. drehbaren oder rotierenden Kathoden die Targetoberflächen gewölbt und insbesondere in Form eines zylinderartigen Rohres ausgebildet. Durch die ständige Drehung eines zylinderartigen Rohres während der Beschichtung wird das Targetmaterial gleichmäßig zerstäubt, ohne dass es zu einer lokal konzentrierten Zerstäubung und somit Furchenbildung kommt, was wiederum die Beschichtungsqualität beeinträchtigen könnte.

Durch den Einsatz von sog. Magnetronkathoden bzw. Magnetrons, bei denen Magnetanordnungen hinter dem zu zerstäubenden Target zu einer erleichterten Plasmabildung bzw. Stabilisierung und Vergleichmäßigung des Plasmas vor dem Target führen, kann ebenfalls eine verbesserte Abscheidung erzielt werden. Insbesondere ist es auch bekannt, sog. rotier- bzw. drehbare Magnetronkathoden (rotatable Magnetrons) einzusetzen, bei denen konzentrisch innerhalb des zylinderrohrartigen Targets Magnete bzw. Magnetanordnungen vorgesehen sind. Derartige drehbare Magnetronkathoden werden beispielsweise in kontinuierlich arbeitenden Durchlaufbeschichtungsanlagen für die Beschichtung von Architekturverglasungen eingesetzt, wobei nach dem Stand der Technik üblicherweise zwei derartige Magnetronkathoden in einer Beschichtungskammer nebeneinander angeordnet sind. Bei einer derartigen Anordnung besteht der Nachteil darin, dass nur ein kleiner Beschichtungsbereich zur Verfügung steht, in dem eine gleichmäßige Beschichtung zur Erzielung einer nahezu konstanten Schichtdicke möglich ist. Aus diesem Grunde müssen die Substrate auch bewegt werden, wenn größere Flächen bzw. Substrate beschichtet werden sollen.

Es ist deshalb Aufgabe der vorliegenden Erfindung eine Beschichtungsvorrichtung und speziell eine Kathodenanordnung bereitzustellen, bei der ein großflächiger Bereich gleichmäßig mit einer Schicht versehen werden kann, wobei jedoch zusätzlich insbesondere gewährleistet werden soll, dass die Materialverluste bei der Beschichtung, der sog. overspray, gering gehalten werden. Zudem soll die Vorrichtung einfach aufgebaut und betreibbar sein.

Dies Aufgabe wird gelöst durch eine Beschichtungsvorrichtung mit den Merkmalen des Anspruchs 1. Vorteilhafte Ausgestaltungen sind Gegenstand der abhängigen Ansprüche.

Mit der Erfindung wird somit erstmals das Problem gelöst, einen großen Beschichtungsbereich mit einer gleichmäßigen Schicht mit gleichmäßiger Schichtdicke versehen zu können, ohne dass ein großer Materialverlust an Beschichtungsmaterial in Kauf genommen werden muss. D. h. es wird die Möglichkeit geschaffen großflächig Substrate statisch, also ohne Bewegung des Substrats, beschichten zu können. Überraschend hat sich nämlich gezeigt, dass bei Verwendung von Kathodenanordnungen mit drehbaren, gewölbten Targets, insbesondere in der Form von Zylinderrohren, mehrere Kathoden, insbesondere mindestens drei vorzugsweise jedoch vier, fünf, sechs oder mehr Kathoden nebeneinander angeordnet werden können, so dass ein großer Beschichtungsbereich entsteht, bei dem durch die spezielle Zerstäubung an einer gewölbten Targetoberfläche eine gleichmäßige Schichtaufbringung, insbesondere zur Erzielung einer gleichmäßigen und einheitlichen Schichtdicke erreicht werden kann, ohne dass ein übermäßiger Verlust an Beschichtungsmaterial in Kauf genommen werden muss. Hierzu trägt wesentlich die gewölbte Targetoberfläche bei, wobei nach bevorzugten Ausführungsformen die Vergleichmäßigung der großflächig abgeschiedenen Schicht bei geringem Materialverlust noch dadurch verstärkt werden kann, dass durch die Gestaltung der Kathoden an sich bzw. durch die Anordnung der Vielzahl der Kathoden zueinander der positive Effekt unterstützt bzw. noch verbessert wird.

Bezüglich der Kathodengestaltung hat es sich hier als vorteilhaft erwiesen Magnetronkathoden einzusetzen, die unterhalb des Targets, also im Falle von zylinderrohrartigen Targets im Kern des Zylinderrohres, Magnetfeldanordnungen aufweisen, um ein Plasma vor der Targetoberfläche zu bilden bzw. zu stabilisieren.

Vorzugsweise ist die Magnetanordnung um die Längsachse der Kathode, also im Falle von zylinderrohrartigen Targets um die Zylinderlängsachse dreh- bzw. verschwenkbar, so dass die Magnete bzw. die Magnetanordnung in Richtung auf das Substrat justiert bzw. eingestellt werden kann. Auf diese Weise kann durch Verschwenken der Magnete bzw. Magnetanordnung der Sputterbereich an der Targetoberfläche in Richtung auf das Substrat verändert werden, wobei durch eine entsprechende Einstellung eine Vergleichmäßigung der Schichtabscheidung bzw. der Schichtdicke über dem Substrat erzielt werden kann.

Insbesondere kann nach einer vorteilhaften Ausgestaltung die Beschichtungsvorrichtung so eingerichtet sein, dass die Magnete bzw. Magnetanordnung während des Beschichtungsvorgangs ständig um eine bestimmte Position schwanken bzw. schwankt, also sich hin und her bewegen, was ebenfalls zu einer Vergleichmäßigung der Schichtabscheidung führt.

Darüber hinaus können die Magnete der Magnetanordnungen auch innerhalb der Magnetanordnung verschwenkbar oder verschiebbar sein, um so den Magnetfeldbereich variieren zu können, was wiederum die Schichtabscheidung positiv beeinflusst. Beispielsweise kann die Magnetanordnung bei einem zylinderrohrartigen Target in einem Zylinderrohrsegment entlang der Längsachse der Kathode in einem Segmentbereich von 25° ausgerichtet auf das Substrat angeordnet sein. Um den Magnetfeldbereich zu vergrößern könnte z. B. der Segmentbereich durch Verschieben bzw. durch Verschwenken der äußeren Magnete um die Kathodenlängsachse nach außen vergrößert werden, so dass die Magnete in einem Segmentbereich von beispielsweise 35° angeordnet sind.

Beim Schwingen oder Schwanken (Wobbeln) der Magnete bzw. Magnetanordnung um eine Position kann zudem auch die Geschwindigkeit mit der die Magnete bzw. die Magnetanordnung bewegt werden, definiert bzw. in unterschiedlicher Weise eingestellt werden, so dass beispielsweise bei der Hin- und Her-Bewegung der Magnete bzw. der Magnetanordnung um eine O-Position je nach Position die Geschwindigkeit absoulut gesehen unterschiedlich ist. Beispielsweise könnte sie zu den Umkehrpunkten hin niedrig und dazwischen hoch gewählt werden.

Vorzugweise können bei einer vorteilhaften Ausgestaltung bei zylinderrohrartigen Targets bzw. Kathoden auf der vom Beschichtungsbereich abgewandten Seite der Kathode im Bereich der Stirnfläche des Targets zusätzliche Magnetanordnung bzw. Magnete vorgesehen werden, so dass sich in diesem Bereich vor der Targetoberfläche ein Plasma ausbilden kann. Auf diese Weise wird vermieden, dass sich Ablagerungen, sog. re-deposition, auf dem Target bilden können.

Neben der Ausgestaltung der Kathodenanordnung mit drehbaren, gewölbten Targets durch entsprechende Magnete und Magnetanordnungen zur positiven Beeinflussung des Abscheideprozesses wird die gleichmäßige Abscheidung einer Beschichtung mit gleichmäßiger Schichtdicke auf einem großflächigen Beschichtungsbereich dadurch verbessert und unterstützt werden, dass die Kathodenanordnungen, die nebeneinander in einer Beschichtungskammer für einen einzelnen, zusammenhängenden, großflächigen Beschichtungsbereich vorgesehen sind, mit unterschiedlichem Abstand zum Beschichtungsbereich bzw. zum Substrat angeordnet werden, und zwar auf einer um den Beschichtungsbereich gewölbten Fläche.

Hierbei hat es sich bewährt, diese gewölbte Fläche als eine Zylinderfläche auszubilden, so dass im Querschnitt die Kathoden im wesentlichen auf einer Kreisbahn angeordnet sind, wobei die Kathoden vorzugsweise mit ihren Längsachsen parallel ausgerichtet und äquidistant beabstandet zueinander angeordnet sind.

Bei einer weiteren vorteilhaften Ausgestaltung kann die Platzierung der Kathodenanordnungen so ausgebildet sein, dass die beiden Kathoden an den Rändern der Kathodenreihe weiter in Richtung des Substrats nach innen versetzt und/oder näher zu den benachbarten Kathoden gerückt werden. Dies beeinflusst die gleichmäßige Schichtabscheidung insbesondere im Randbereich des Beschichtungsbereichs ebenfalls positiv.

Der Radius der Kreisbahn bzw. der Mantelfläche des Zylinders, auf dem die Kathoden angeordnet sind, wird vorzugsweise im Vergleich zum Abstand der Kathoden zum Substrat bzw. Beschichtungsbereich sehr groß gewählt, so dass nur eine geringe Wölbung der Fläche vorhanden ist, entlang der die Kathoden angeordnet sind.

Bei einer Platzierung der Kathoden auf einer Kreisbahn bzw. einer Mantelfläche eines Zylinders ist es insbesondere sehr vorteilhaft, wenn die Magnete oder Magnetanordnungen der Magnetronkathoden in radialer Richtung auf den Beschichtungsbereich ausgerichtet sind, also die Mittelsenkrechten durch die Magnetsätze vorzugsweise aller Kathoden in Richtung auf das Zentrum des Kreises bzw. des Zylinders, entlang dem die Kathoden angeordnet sind, weisen. Allerdings ist auch hier ein Verschwenken bzw. Schwingen der Magnete bzw. Magnetanordnungen um diese Position denkbar.

Obwohl mit der vorliegenden Beschichtungsvorrichtung bzw. Kathodenanordnung bzw. Kathodengestaltung insbesondere eine statische Beschichtung eines großflächigen Bereiches, also ohne Bewegung des Substrats möglich wird, ist natürlich auch eine Bewegung des Substrats durch eine Transporteinrichtung möglich, wobei auch hier der Vorteil eines größeren Beschichtungsbereichs genutzt werden kann.

Der Beschichtungsbereich selbst ist üblicherweise planar, kann jedoch auch gewölbt sein, wobei dann lediglich eine entsprechende Anpassung der Lage der Kathodenanordnungen erforderlich ist, so dass der Bezug zwischen Lage des Beschichtungsbereichs und Platzierung der Kathoden erhalten bleibt.

Die dreh- oder rotierbaren Magnetkathoden mit Zylinderrohrtarges sind vorzugsweise einseitig an einer Stirnseite gelagert und zwar insbesondere an einem fahrbaren Wagen oder Schlitten, so dass sie einfach in eine Beschichtungskammer eingebracht und aus dieser entfernt werden können.

Weitere Vorteile, Kennzeichen und Merkmale der vorliegenden Erfindung werden bei der nachfolgenden Beschreibung eines bevorzugten Ausführungsbeispiels deutlich. Die Figuren zeigen dabei in rein schematischer Weise in
- Fig. 1: eine Schnittansicht bezüglich der Anordnung von Kathoden und Substrat in einer Beschichtungskammer; und in
- Fig. 2: ein Diagramm, das die normierte Schichtdicke über der Länge eines Substrats zeigt.

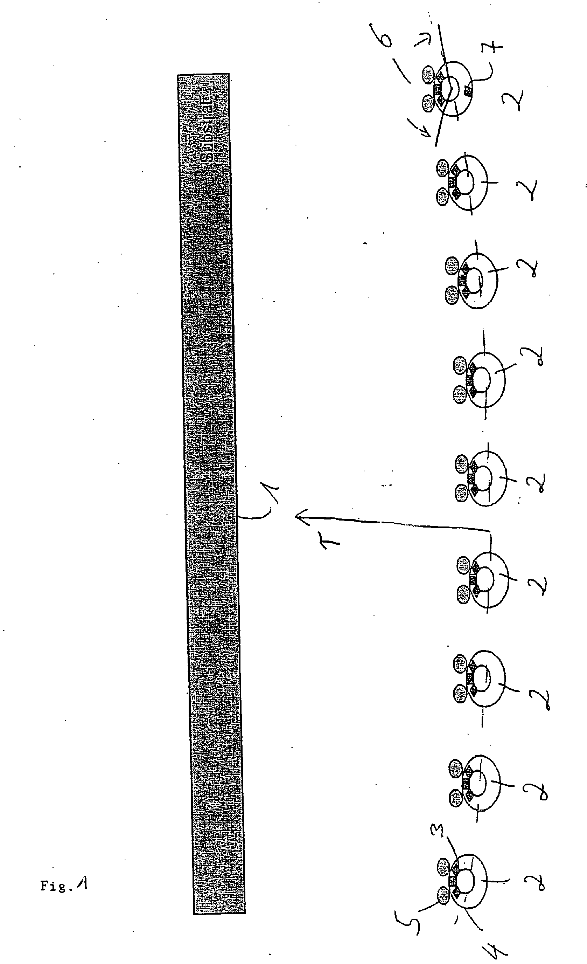

Fig. 1 zeigt in einer rein schematischen Schnittansicht die Anordnung von Substrat bzw. Beschichtungsbereich 1 und einer Vielzahl von Kathoden 2.

Bei den Kathoden 2 handelt es sich um sog. drehbare Magnetronkathoden, bei denen ein zylinderförmiges Target 4 um die Kathodenlängsachse drehbar ist. Die Magnete 3 der Magnetanordnung erzeugen bzw. stabilisieren ein Plasma 5 welches sich in unmittelbarer Nähe zur Targetoberfläche bildet. Durch die ständige und kontinuierliche Drehung des Targets 4 während des Beschichtungsprozesses kommt es zu einer gleichmäßigen Materialabtragung bzw. Zerstäubung über die gesamte Targetoberfläche.

Um eine optimale Beschichtung des Substrats im Beschichtungsbereich 1 zu erzielen, sind die Magnetanordnungen in Richtung auf das Substrat angeordnet, wobei die Magnetanordnungen, wie durch den Winkelbereich 6 angedeutet ist, über einen gewissen Winkelbereich um die Kathodenlängsachse verdrehbar sind, um eine optimale Ausrichtung des Zerstäubungsbereichs auf der Targetoberfläche in Richtung Substrat zu gewährleisten.

Neben einer fixen Ausrichtung der Magnetanordnungen 3 in Richtung auf das Substrat kann auch eine Hin- und Her-Bewegung der Magnetanordnungen 3 während des Beschichtungsprozesses durchgeführt werden, um so die Gleichmäßigkeit der Schichtdicke auf dem Substrat zu verbessern.

Um darüber hinaus Abscheidungen bzw. sog. Rücksputtern (re-deposition), insbesondere an den Endbereichen der Magnetronkathoden, also an den Mantelflächen im Bereich der Stirnflächen der zylinderrohrartigen Targets 4 zu vermeiden, kann gegenüberliegend von der Magnetanordnung 3 eine zweite Magnetanordnung 7 vorgesehen sein, um durch Erzeugung eines Plasmas an den Endbereichen der zylinderartigen Magnetronkathode eine Abscheidung zu vermeiden.

Die rotierbaren Magnetronkathoden (rotatable magnetrons) können jeweils über die Stimbereiche an den Beschichtungskammerenden gelagert sein. Vorzugsweise sind die rotierbaren Magnetronkathoden an einer Kammerwandseite einseitig im Stimflächenbereich des Targetrohrs durch ein konzentrisch in dieses eingreifendes Halteelement an einem von der Beschichtungskammer herausfahrbaren Wagens angeordnet, um auf diese Weise einen leichten Kathodenwechsel vomehmen zu können. Vorzugsweise müssen derartige sog. cantilevered Magnetrons auf der gegenüberliegenden Kammerwandseite nicht durch ein Auflager gestützt werden, wobei jedoch diese Option auch verwirklicht werden kann.

Wie ebenfalls aus der Fig. 1 zu erkennen ist, sind die Kathoden 2 nicht planar in einer Ebene angeordnet, sondern weisen einen unterschiedlichen Abstand zum Beschichtungsbereich 1 bzw. Substrat auf. Bei der Ausführungsform der Fig. 1 sind die drehbaren Magnetronkathoden 2 insbesondere auf einer Kreisbahn angeordnet, die einen Radius r aufweist, der sehr viel größer als der Abstand zwischen drehbaren Magnetronkathoden und Substrat ist. Dies ist mit dem Pfeil bei r angedeutet. Entsprechend ergibt sich als räumliche Anordnung, dass die sich senkrecht zur Bildebene erstreckenden zylinderrohrartigen Targets 4 bzw. rotierbaren Magnetronkathoden auf der Mantelfläche eines Zylinders mit dem Radius r angeordnet sind, während das Substrat bzw. der Beschichtungsbereich 1 flach und eben ist. Diese räumliche Anordnung bewirkt, dass für großflächige Substrate beispielsweise Substrate mit einer Ausdehnung von 1500 x 1800 mm eine gleichmäßige Beschichtung erzielt werden kann, ohne dass das Substrat bewegt werden muss (statische Beschichtung). Dies bedeutet auch für den Fall von beweglichen Substraten, also sog. kontinuierlichen Durchlaufbeschichtungsanlagen (Inlinebeschichtung), dass ein großer Beschichtungsbereich mit einer gleichmäßig dicken Beschichtung erzielt werden kann..

Durch die räumliche Anordnung der Kathoden bezüglich des Beschichtungsbereichs 1 wird auch gewährleistet, dass eine hohe Ausnutzung des zerstäubten Materials vorliegt (Collection Efficeiency), so dass umgekehrt bezogen auf die Menge des abzuscheidenden Materials die Anzahl der Kathodenanordnungen minimiert werden kann.

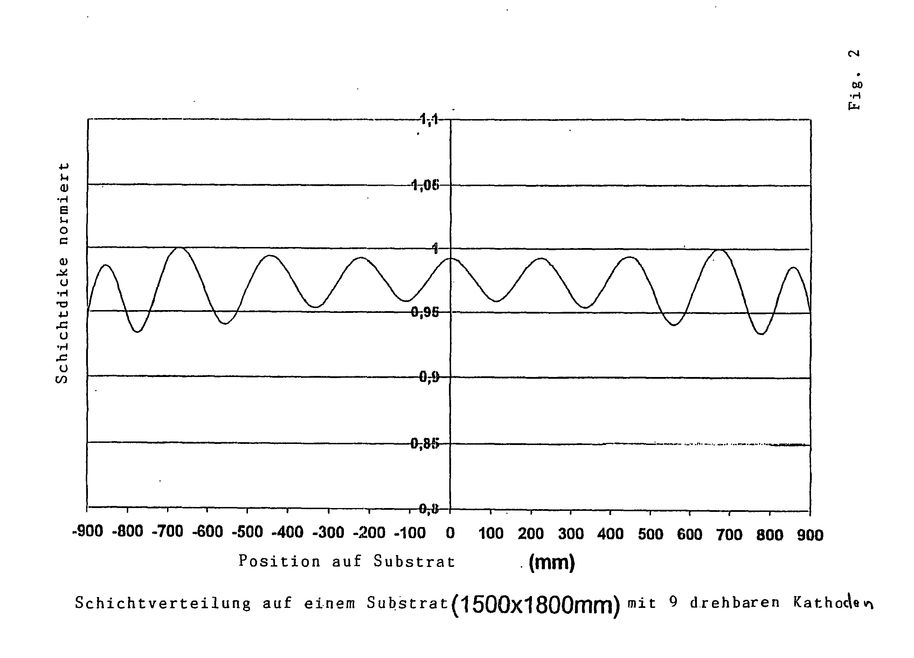

Fig. 2 zeigt eine Berechnung bezüglich der Schichtdickenverteilung über der Substratlänge bei einer Kathodenanordnung gemäß Fig. 1 mit neun rotierbaren Magnetronkathoden bei einer Substratlänge von 1800 mm. In dem Diagramm der Fig. 2 ist die auf 1 normierte Schichtdicke über die Länge des Substrats aufgetragen, wobei zu erkennen ist, dass sich die nonnierte Schichtdicke von den äußersten Rändern bis zur Mitte im Wesentlichen in einem Bereich von 0,95 bis 1 bewegt.

## Patentansprüche

1. Beschichtungsvorrichtung zum Beschichten von großflächigen Substraten mittels Kathodenzerstäubung mit einer Beschichtungskammer und einer darin vorhandenen Kathodenanordnung (2), bei der das zu zerstäubende Material auf einem Target (4) mit einer zylindrischen Oberfläche angeordnet ist, wobei im Innern des Targets (4) Magnete oder Magnetanordnungen angeordnet sind sowie Mittel, das Target (4) während des Beschichtungsvorgangs kontinuierlich um die Magnete oder Magnetanordnungen zu drehen,
**dadurch gekennzeichnet, dass**
in einer einzigen Beschichtungskammer für einen zusammenhängenden Beschichtungsbereich mindestens drei Kathodenanordnungen (2) mit drehbaren, zylindrischen Targets (4) nebeneinander und entlang einer um den Beschichtungsbereich gewölbten Fläche angeordnet sind und so eine gleichmäßige Beschichtung auch bei großflächigen, statischen Substraten ermöglichen.

2. Beschichtungsvorrichtung nach Anspruch 1,
**dadurch gekennzeichnet, dass**
die Kathodenanordnungen mit drehbaren, zylindrischen Targets (4) einseitig im Bereich einer Stirnseite gelagert sind.

3. Beschichtungsvorrichtung nach Anspruch 1 oder 2,
**dadurch gekennzeichnet, dass**
die Magnetionkathoden um die Kathodenlängsachse dreh- oder verschwenkbare Magnete (3) oder Magnetanordnungen aufweisen.

4. Beschichtungsvorrichtung nach Anspruch 1 oder 2,
**dadurch gekennzeichnet, dass**
die Magnete (3) der Magnetanordnungen in den Randbereichen zur Vergrößerung des Magnetfeldbereichs (6) verschwenkbar oder verschiebbar sind.

5. Beschichtungsvorrichtung nach einem der vorhergehenden Ansprüche,
**dadurch gekennzeichnet, dass**
die Vielzahl der Kathodenanordnungen bezüglich des im Beschichtungsbereich anzuordnenden Substrats mit unterschiedlichem Abstand angeordnet sind.

6. Beschichtungsvorrichtung nach einem der vorhergehenden Ansprüche,
**dadurch gekennzeichnet, dass**
die Vielzahl der Kathodenanordnungen mit ihren Längsachsen parallel ausgerichtet und zueinander beabstandet angeordnet sind, wobei die Kathodenanordnungen zueinander äquidistant angeordnet sind und lediglich die äußeren Kathodenanordnungen zu ihren benachbarten Kathoden einen verringerten Abstand aufweisen.

7. Beschichtungsvorrichtung nach einem der Ansprüche 5 bis 6,
**dadurch gekennzeichnet, dass**
die Kathodenanordnungen auf einer Mantelfläche eines Zylinders angeordnet sind, dessen Zylinderlängsachse von den Kathodenanordnungen aus gesehen im Beschichtungsbereich oder dahinter liegt, wobei lediglich die beiden äußeren Kathodenanordnungen von der Mantelfläche in Richtung Beschichtungsbereich versetzt sind.

8. Beschichtungsvorrichtung nach Anspruch 7,
**dadurch gekennzeichnet, dass**
der Radius des Zylinders im Vergleich zum Abstand Beschichtungsbereich-Kathodenanordnungen groß ist.

9. Beschichtungsvorrichtung nach einem der vorhergehenden Ansprüche,
**dadurch gekennzeichnet, dass**
die Magnete oder Magnetanordnungen der Kathodenanordnungen in radialer Richtung auf den Beschichtungsbereich ausgerichtet sind, wobei sie um diese Lage mit definierten Geschwindigkeiten verschwenkbar sind.

10. Beschichtungsvorrichtung nach einem der vorhergehenden Ansprüche,
**dadurch gekennzeichnet, dass**
im Bereich der vom Beschichtungsbereich abgewandten Seite in den Stirnflächenbereichen der Kathodenanordnungen zusätzliche Magnete oder Magnetanordnungen angeordnet sind, die durch Erzeugung eines Plasmas während der Beschichtung Ablagerungen vermeiden.

11. Beschichtungsvorrichtung nach einem der vorhergehenden Ansprüche,
**dadurch gekennzeichnet, dass**
das Substrat durch eine Transporteinrichtung während der Beschichtung bewegt ist.

## Claims

1. Coating apparatus for coating large-area substrates by cathode sputtering, with a coating chamber containing a cathode arrangement (2) in which the material to be sputtered is arranged on a target (4) with a cylindrical surface, magnets or magnet arrangements being arranged in the interior of the target (4), and means for rotating the target (4) continuously about the magnets or magnet arrangements during the coating process,
**characterized in that**
in a single coating chamber, for a continuous coating zone, at least three cathode arrangements (2) with rotatable cylindrical targets (4) are arranged side by side along a surface curved around the coating zone, thus allowing uniform coating of static substrates including those with large surface areas.

2. Coating apparatus according to Claim 1,
**characterized in that**
the cathode arrangements with rotatable cylindrical targets (4) are mounted single-endedly in the region of an end face.

3. Coating apparatus according to Claim 1 or Claim 2,
**characterized in that**
the magnetron cathodes have magnets (3) or magnet arrangements rotatable or pivotable about the longitudinal axis of the cathode.

4. Coating apparatus according to Claim 1 or Claim 2,
**characterized in that**
the magnets (3) of the magnet arrangements in the edge regions are pivotable or displaceable in order to enlarge the magnetic field zone (6).

5. Coating apparatus according to any one of the preceding claims,
**characterized in that**
the plurality of cathode arrangements are placed at different distances from the substrate to be placed in the coating zone.

6. Coating apparatus according to any one of the preceding claims,
**characterized in that**
the plurality of cathode arrangements are arranged with their longitudinal axes aligned parallel with each other and spaced apart, the cathode arrangements being arranged equidistantly from each other and only the outer cathode arrangements being placed at a smaller distance from their adjacent cathodes.

7. Coating apparatus according to either of Claims 5 and 6,
**characterized in that**
the cathode arrangements are arranged on a circumferential surface of a cylinder whose longitudinal axis viewed from the cathode arrangement lies within or behind the coating zone, only the two outer cathode arrangements being displaced away from the circumferential surface towards the coating zone.

8. Coating apparatus according to Claim 7,
**characterized in that**
the radius of the cylinder is large in relation to the distance between the coating zone and the cathode arrangements.

9. Coating apparatus according to any one of the preceding claims,
**characterized in that**
the magnets or magnet arrangements of the cathode arrangements are radially orientated towards the coating zone and can be pivoted about this position at defined rates.

10. Coating apparatus according to any one of the preceding claims,
**characterized in that**
additional magnets or magnet arrangements are arranged in the end regions of the cathode arrangements remote from the coating zone, to prevent deposits by generating a plasma during coating.

11. Coating apparatus according to any one of the preceding claims,
**characterized in that**
the substrate is moved by a transport device during coating.

## Revendications

1. Dispositif de revêtement pour le revêtement de substrats à grande surface au moyen d'une pulvérisation cathodique comprenant une chambre de revêtement et un arrangement de cathode (2) à l'intérieur de celle-ci, dans lequel la matière à pulvériser est disposée sur une cible (4) ayant une surface cylindrique, dans lequel des aimants ou des arrangements d'aimants sont disposés à l'intérieur de la cible (4) ainsi que des moyens qui, pendant le procédé de revêtement, font tourner en continu la cible (4) autour des aimants ou des arrangements d'aimants,
**caractérisé en ce que**
au moins trois arrangements de cathode (2) comprenant des cibles cylindriques rotatives (4) sont disposés côte à côte et le long d'une surface courbée autour de la zone de revêtement dans une chambre de revêtement unique fournissant une zone de revêtement ininterrompue et permettent ainsi un revêtement homogène même de substrats statiques à grande surface.

2. Dispositif de revêtement selon la revendication 1,
**caractérisé en ce que**
les arrangements de cathode comprenant les cibles cylindriques rotatives (4) sont logés sur un côté dans la zone d'une face frontale.

3. Dispositif de revêtement selon la revendication 1 ou 2,
**caractérisé en ce que**
les cathodes magnétron présentent des aimants (3) ou des arrangements d'aimants qui peuvent tourner ou pivoter autour de l'axe longitudinal de la cathode.

4. Dispositif de revêtement selon la revendication 1 ou 2,
**caractérisé en ce que**
les aimants (3) des arrangements d'aimants peuvent être pivotés ou décalés dans les zones marginales afin d'agrandir la zone du champ magnétique (6).

5. Dispositif de revêtement selon l'une quelconque des revendications précédentes,
**caractérisé en ce que**
la pluralité d'arrangements de cathode est disposée avec des distances variables par rapport au substrat à placer dans la zone de revêtement.

6. Dispositif de revêtement selon l'une quelconque des revendications précédentes,
**caractérisé en ce que**
la pluralité des arrangements de cathode est disposée parallèlement selon leurs axes longitudinaux et à distance les uns des autres, dans lequel les arrangements de cathode sont placés à équidistance les uns des autres et seuls les arrangements de cathode externes présentent une plus petite distance par rapport à leurs cathodes adjacentes.

7. Dispositif de revêtement selon l'une quelconque des revendications 5 à 6,
**caractérisé en ce que**
les arrangements de cathode sont disposés sur une surface d'enveloppe d'un cylindre, dont l'axe longitudinal de cylindre, vu depuis les arrangements de cathode, se trouve dans la zone de revêtement ou derrière celle-ci, seuls les deux arrangements de cathode externes étant décalés de la surface d'enveloppe en direction de la zone de revêtement.

8. Dispositif de revêtement selon la revendication 7,
**caractérisé en ce que**
le rayon du cylindre est grand par rapport à la distance séparant la zone de revêtement des arrangements de cathode.

9. Dispositif de revêtement selon l'une quelconque des revendications précédentes,
**caractérisé en ce que**
les aimants ou les arrangements d'aimants des arrangements de cathode sont orientés radialement par rapport à la zone de revêtement, où ils peuvent pivoter autour de cette position avec des vitesses définies.

10. Dispositif de revêtement selon l'une quelconque des revendications précédentes,
**caractérisé en ce que**
des aimants supplémentaires ou des arrangements d'aimants supplémentaires qui empêchent la formation de dépôts pendant le revêtement grâce à la production d'un plasma, sont disposés dans les zones des surfaces frontales des arrangements de cathode au niveau du côté opposé à la zone de revêtement.

11. Dispositif de revêtement selon l'une quelconque des revendications précédentes,
**caractérisé en ce que**
pendant le revêtement, le substrat est déplacé au moyen d'un dispositif de transport.
